(19) Europäisches Patentamt

European Patent Office

Office européen des brevets

(11) **EP 1 617 275 A1**

(12) **EUROPÄISCHE PATENTANMELDUNG**

(43) Veröffentlichungstag:
 **18.01.2006 Patentblatt 2006/03**

(51) Int Cl.:
 *G02B 27/09* (2006.01)     *H01S 3/00* (2006.01)

(21) Anmeldenummer: **05014423.7**

(22) Anmeldetag: **02.07.2005**

(84) Benannte Vertragsstaaten:
 **AT BE BG CH CY CZ DE DK EE ES FI FR GB GR HU IE IS IT LI LT LU LV MC NL PL PT RO SE SI SK TR**
 Benannte Erstreckungsstaaten:
 **AL BA HR MK YU**

(30) Priorität: **14.07.2004 DE 102004034253**

(71) Anmelder: **Hentze-Lissotschenko Patentverwaltungs GmbH & Co. KG**
 **36419 Gerstengrund (DE)**

(72) Erfinder:
 • **Mitra, Thomas, Dr.**
  **44319 Dortmund (DE)**
 • **Meinschien, Jens, Dr.**
  **44319 Dortmund (DE)**
 • **Hill, Wieland, Dr.**
  **44388 Dortmund (DE)**

(74) Vertreter: **Basfeld, Rainer et al**
 **Fritz Patent- und Rechtsanwälte**
 **Postfach 15 80**
 **59705 Arnsberg (DE)**

(54) **Vorrichtung für die Beleuchtung einer Fläche mit einem Halbleiterlaserbarren und Strahltransformationsmitteln**

(57)     Vorrichtung für die Beleuchtung einer Fläche, umfassend mindestens einen Halbleiterlaserbarren (1) mit einer Mehrzahl von Emittern, bei denen der Abstand der einzelnen Emitter zueinander kleiner ist als die Ausdehnung der Emitter in der ersten Richtung (X), Strahltransformationsmittel (3) zur Transformation des aus den Emittern austretenden Laserlichts, die derart ausgebildet sind, dass sie die Divergenz des Laserlichts hinsichtlich der ersten Richtung (X) mit der Divergenz hinsichtlich der zweiten Richtung (Y) tauschen können, wobei die Strahltransformationsmittel (3) einen derartigen Abstand zu dem Laserdiodenbarren (1) aufweisen, das zumindest das Laserlicht zweier direkt benachbarter Emitter bei dem Auftreffen auf die Strahltransformationsmittel (3) in der ersten Richtung (X) miteinander überlappt ist.

## Fig. 1a

## Beschreibung

Die vorliegende Erfindung betrifft eine Vorrichtung für die Beleuchtung einer Fläche, umfassend mindestens einen Halbleiterlaserbarren mit einer Mehrzahl von Emittern, die in einer ersten Richtung nebeneinander und beabstandet zueinander angeordnet sind, wobei der Abstand der einzelnen Emitter zueinander kleiner ist als die Ausdehnung der Emitter in der ersten Richtung und wobei die Divergenz des aus den einzelnen Emittern austretenden Laserlichts hinsichtlich der ersten Richtung kleiner ist als die Divergenz des Laserlichts hinsichtlich einer zu der ersten Richtung senkrechten zweiten Richtung, sowie weiterhin umfassend Kollimationsmittel für die zumindest teilweise Kollimation des aus den Emittern austretenden Laserlichts.

Vorrichtungen der vorgenannten Art sind hinlänglich bekannt. Halbleiterlaserbarren mit sehr kleinem Abstand zwischen den einzelnen Emittern sind in der Regel als QCW-Barren ausgeführt, die quasi kontinuierlich betrieben werden können. Bei Halbleiterlaserbarren und auch bei QCW-Barren ist die Divergenz in der sogenannten Fast-Axis, d. h. in der zweiten Richtung oder der Richtung senkrecht zu der Richtung, in der die Emitter nebeneinander angeordnet sind, deutlich größer als in der sogenannten Slow-Axis bzw. der ersten Richtung. Trotzdem ist das aus dem Halbleiterlaserbarren austretende Laserlicht hinsichtlich der Slow-Axis-Richtung schwieriger kollimierbar, weil zum einen die Emitter in der Slow-Axis-Richtung ausgedehnt sind und zum anderen weil eine ganze Reihe von Emittern nebeneinander angeordnet sind. Daher wird bei Halbleiterlaserbarren, die nicht als QCW-Barren ausgeführt sind, bei denen also der Abstand der einzelnen Emitter zueinander in der Regel größer ist als die Ausdehnung der Emitter in der Slow-Axis-Richtung, vor der Kollimierung der Slow-Axis ein Strahltransformationsmittel in den Strahlengang eingebracht. Diese beispielsweise aus der EP 1 006 382 B1 bekannten Strahltransformationsmittel können das Laserlicht drehen bzw. die Divergenz des Laserlichtes hinsichtlich der ersten oder der Slow-Axis-Richtung mit der Divergenz hinsichtlich der zweiten oder der Fast-Axis-Richtung tauschen. Weiterhin sind diese Strahltransformationsmittel derart nahe an den Halbleiterlaserbarren angeordnet, dass das Licht aus einzelnen Emittern vor dem Eintritt in die Strahltransformationsmittel noch nicht miteinander überlappt ist. Dadurch wird die Möglichkeit geschaffen, Slow-Axis-Kollimationsmittel in einem relativ großen Abstand zu dem Halbleiterlaserbarren anzuordnen, so dass in Slow-Axis-Richtung eine große Strahlausdehnung erzielt wird, die wiederum eine kleine Divergenz in die Slow-Axis-Richtung und auch eine gute Kollimierbarkeit ermöglicht. Bei QCW-Barren sind derartige Anordnungen bisher nicht realisiert worden, so dass die Kollimierbarkeit des von QCW-Barren ausgehenden Laserlichtes sehr schlecht ist.

Weiterhin erweist sich bei der Verwendung eines Halbleiterlaserbarrens für die Beleuchtung einer Fläche bzw. für den Betrieb eines Freistrahlers die unterschiedliche Divergenz von Fast-Axis und Slow-Axis bzw. die schlechte Kollimierbarkeit des Slow-Axis als nachteilig.

Das der vorliegenden Erfindung zugrunde liegende Problem ist die Schaffung einer Vorrichtung der eingangs genannten Art, die effektiver zur Beleuchtung einer Fläche verwendet werden kann.

Dies wird erfindungsgemäß durch eine Vorrichtung der eingangs genannten Art mit den kennzeichnenden Merkmalen der Ansprüche 1 und/oder 2 erreicht.

Gemäß Anspruch 1 ist vorgesehen, dass die Beleuchtungsvorrichtung Strahltransformationsmittel zur Transformation des aus den Emittern austretenden Laserlichts umfasst, die derart ausgebildet und im Strahlengang des aus den Emittern austretenden Laserlichts angeordnet sind, dass sie die Divergenz des Laserlichts hinsichtlich der ersten Richtung mit der Divergenz hinsichtlich der zweiten Richtung tauschen können, wobei die Strahltransformationsmittel einen derartigen Abstand zu dem Laserdiodenbarren aufweisen, das zumindest das Laserlicht zweier direkt benachbarter Emitter bei dem Auftreffen auf die Strahltransformationsmittel in der ersten Richtung miteinander überlappt ist.

Es hat sich überraschend gezeigt, dass bei der Verwendung von Strahltransformationsmitteln bei Halbleiterlaserbarren mit geringem Abstand zwischen den einzelnen Emittern, also beispielsweise bei QCW-Barren, trotz der Überlappung des Laserlichtes benachbarter Emitter vor dem Auftreffen auf die Strahltransformationsmittel nur vergleichsweise geringe Verluste auftreten. Beispielsweise sind die durch das vorherige Überlappen in den Strahltransformationsmitteln auftretenden Verluste kleiner als 5%. Durch die auf diese Weise überraschend mögliche Verwendung von Strahltransformationsmitteln auch für QCW-Barren lässt sich die Kollimierbarkeit und somit die Verwendbarkeit als Freistrahler bzw. für die Beleuchtung einer Fläche deutlich verbessern.

Gemäß Anspruch 2 kann vorgesehen sein, dass die Beleuchtungsvorrichtung Homogenisatormittel zur Homogenisierung des aus den Emittern austretenden Laserlichts umfasst. Durch die Verwendung von Homogenisatormitteln kann die Homogenität und damit die Strahlqualität deutlich verbessert werden, so dass eine weit von der Vorrichtung entfernte Fläche sehr gleichmäßig ausgeleuchtet werden kann.

Die gleichmäßige Ausleuchtung einer von der Vorrichtung weit entfernten Fläche kann vielfältige Anwendungen finden. Beispiele sind blendfreie Nachtsichtsysteme im Straßen- und Schienenverkehr sowie im messtechnischen Bereich die digitale Bilderfassung zur Produktionskontrolle von Verpackungen wie beispielsweise Lebensmittelverpackungen. Aufgrund der gleichmäßigen Ausleuchtung der Fläche und aufgrund der besseren Kollimierbarkeit durch die erfindungsgemäße Vorrichtung ergeben sich eine Reihe von Vorteilen. Die Intensitätsverteilung im Bereich der beleuchteten Fläche weist sehr steile Flanken auf, so dass im ausgeleuchteten Bereich eine höhere Intensität erzielbar ist, weil in den benachbarten Bereichen nur eine sehr geringe Verlustleistung auftritt. Auf diese Weise kann die Leistungsaufnahme des Beleuchtungssystems reduziert werden bzw. kann die Anzahl der Emitter oder Halbleiterlaserbarren verringert werden. Weiterhin führt die homogenere Intensitätsverteilung zu einem besseren Bildkontrast und erlaubt beispielsweise bei digitaler Bilderfassung den Einsatz preiswerterer Kameras.

Gemäß Anspruch 3 kann vorgesehen sein, dass die Homogenisatormittel mehrstufig ausgebildet sind. Dabei kann insbesondere gemäß Anspruch 4 vorgesehen sein, dass die Anzahl der Stufen der Homogenisatormittel für die Homogenisierung hinsichtlich der ersten Richtung größer ist als für die Homogenisierung hinsichtlich der zweiten Richtung. Da das Laserlicht hinsichtlich der zweiten Richtung bzw. hinsichtlich der Fast-Axis eine deutlich bessere Kollimierbarkeit aufweist, erweist sich in der Regel eine Homegenisatorstufe für die Fast-Axis als ausreichend. Durch die Verwendung einer Stufe für die Fast-Axis und zweier Stufen für die Slow-Axis ergibt sich ein wesentlich geringerer Fertigungsaufwand als bei einem komplett zweistufigen Homogenisator. Dies hat seinen Grund darin, dass der Abstand der beiden Homogenisierer zueinander nur hinsichtlich einer Achse, nämlich hinsichtlich der Slow-Axis zueinander justiert werden muss. Auf diese Weise kann der Abstand der Homogenisierer optimal an die Erfordernisse hinsichtlich der Slow-Axis angepasst werden. Weiterhin sinken dadurch die Anforderungen an die Brennweitentoleranzen der für die Homogenisierer verwendeten Linsen oder dergleichen.

Gemäß Anspruch 5 kann vorgesehen sein, dass die Strahltransformationsmittel eine Mehrzahl von in der ersten Richtung nebeneinander angeordneten Strahltransformationselementen aufweisen. Gemäß Anspruch 6 kann dabei vorgesehen sein, dass das von einem der Emitter ausgehende Laserlicht auf mehr als eines der Strahltransformationselemente auftrifft. Beispielsweise können dabei gemäß Anspruch 7 Strahltransformationselemente als Zylinderlinsen ausgebildet sein, deren Zylinderachsen unter einem Winkel von etwa 45° und/oder -45° gegen die erste Richtung geneigt sind.

Es besteht weiterhin die Möglichkeit, dass auch die Homogenisatormittel eine Mehrzahl von in der ersten Richtung nebeneinander angeordneten Homogenisatorelementen aufweisen. Hierbei können die Homogenisatorelemente ebenfalls als Zylinderlinsen ausgebildet sein. Es besteht die Möglichkeit, dass der Mittenabstand der Strahltransformationselemente zueinander ungleich dem Mittenabstand der Homogenisatorelemente zueinander ist. Auf diese Weise kann die Intensitätsverteilung im Bereich der zu beleuchtenden Fläche noch homogener gestaltet werden.

Gemäß Anspruch 10 kann vorgesehen sein, dass die Kollimationsmittel Fast-Axis-Kollimationsmittel umfassen, die zur Kollimierung des aus den Emittern austretenden Laserlichtes hinsichtlich der zweiten Richtung dienen. Weiterhin kann gemäß Anspruch 11 vorgesehen sein, dass die Kollimationsmittel Slow-Axis-Kollimationsmittel umfassen, die zur Kollimierung des aus den Emittern austretenden Laserlichtes hinsichtlich der ersten Richtung dienen.

Weiterhin kann gemäß Anspruch 12 vorgesehen sein, dass der Abstand der einzelnen Emitter zueinander in der ersten Richtung weniger als die Hälfte, insbesondere weniger als ein Zehntel, der Ausdehnung eines jeden der Emitter in der ersten Richtung beträgt. Weiterhin kann gemäß Anspruch 13 vorgesehen sein, dass der Halbleiterlaserbarren als QCW-Barren ausgeführt ist.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen

Fig. 1a  eine Seitenansicht einer erfindungsgemäßen Vorrichtung;

Fig. 1b  eine gegenüber Fig. 1a um 90° gedrehte Seitenansicht der erfindungsgemäßen Vorrichtung;

Fig. 2a  eine perspektivische Ansicht der Strahltransformationsmittel der erfindungsgemäßen Vorrichtung;

Fig. 2b  einen schematischen Schnitt längs der Linie IIb-IIb in Fig. 2a;

Fig. 3  eine perspektivische Ansicht der Strahltransformationsmittel mit drei beispielhaften Strahlbündeln;

Fig. 4a  eine Detailansicht auf den Laserdiodenbarren, die Fast-Axis-Kollimationsmittel und die Strahltransformationsmittel mit beispielhaften Teilstrahlen des Laserlichts;

Fig. 4b  eine gegenüber Fig. 4a um 90° gedrehte Detailansicht auf den Laserdiodenbarren, die Fast-Axis-Koilimationsmittel und die Strahltransformationsmittel mit beispielhaften Teilstrahlen des Laserlichts.

In den Figuren sind zur besseren Übersichtlichkeit kartesische Koordinatensysteme eingezeichnet.

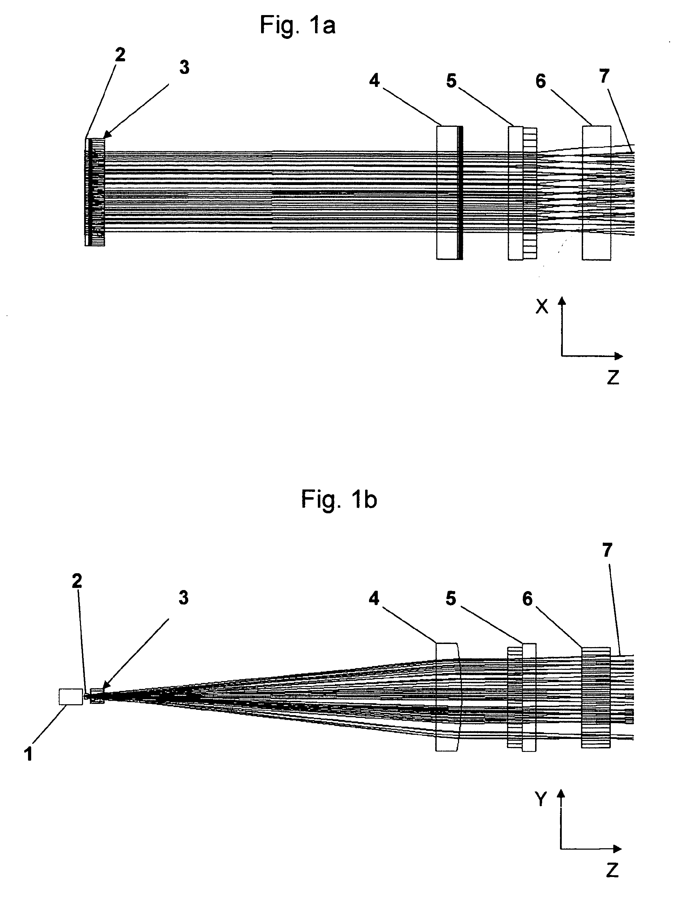

Wie aus Fig. 1a und Fig. 1b ersichtlich ist, umfasst eine erfindungsgemäße Vorrichtung einen Halbleiterlaserbarren 1, der insbesondere als sogenannter QCW-Barren ausgeführt ist. Wie andere Halbleiterlaserbarren weist auch ein QCW-Barren eine Anzahl von in X-Richtung nebeneinander und beabstandet zueinander angeordneter Emitter auf. Allerdings ist bei QCW-Barren der Abstand zwischen den einzelnen Emittern deutlich kleiner als die Ausbreitung der Emitter in X-Richtung.

Bei typischen QCW-Barren sind in X-Richtung, der sogenannten Slow-Axis-Richtung, beispielsweise 60 Emitter nebeneinander und beabstandet zueinander angeordnet. Die Größe der Abstrahlflächen der Emitter kann dabei etwa 1 μm in Y-Richtung, der sogenannten Fast-Axis-Richtung, und etwa 150 μm in X-Richtung betragen. Dabei kann der Abstand zwischen einzelnen Emittern in X-Richtung etwa 10 μm betragen. Dies entspricht einem Mittenabstand (pitch) von etwa 160 μm.

Weiterhin zeichnet QCW-Barren eine sehr große Pulsdauer bei großer Wiederholfrequenz aus, so dass sich ein Duty Cycle von bis zu 20% ergibt. Der Duty Cycle gibt den prozentualen Anteil von Zeitabschnitten wieder, in denen der Emitter Laserlicht aussendet. Typische Pulsdauern eines QCW-Barrens liegen bei 150 μs bei einer Wiederholfrequenz von 1 kHz. Maximale Pulsdauern der QCW-Barren liegen bei etwa 500 μs. Diese Eigenschaften geben dem QCW-Barren ihren Namen, der auf einen quasi kontinuierlichen Betrieb des Halbleiterlaserbarrens schließen lässt.

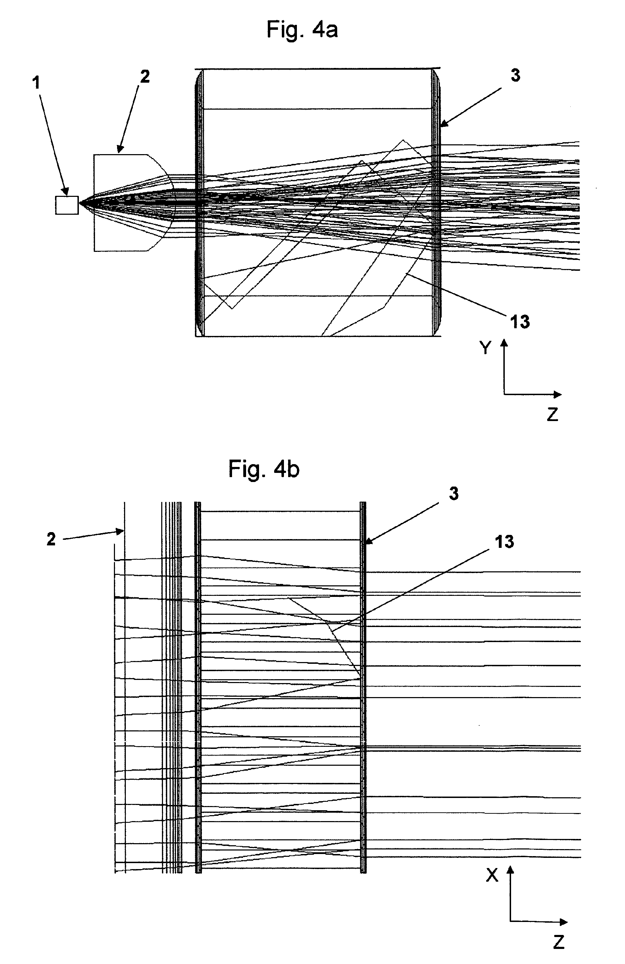

Der Halbleiterlaserbarren 1 ist in Fig. 1 bund Fig. 4a lediglich schematisch durch ein Rechteck dargestellt.

Aus Fig. 4a und Fig. 4b ist ersichtlich, dass sich in Ausbreitungsrichtung Z des aus den einzelnen Emittern des Halbleiterlaserbarrens 1 austretenden Laserlichtes an den Halbleiterlaserbarren 1 Fast-Axis-Kollimationsmittel 2 anschließen. Die Fast-Axis-Kollimationsmittel 2 sind, wie dies aus Fig. 4a und Fig. 4b deutlich ersichtlich ist, beispielsweise als plankonvexe Zylinderlinse ausgebildet, deren Zylinderachse sich in X-Richtung erstreckt. Durch eine derartige Zylinderlinse kann das aus den einzelnen Emittern austretende Laserlicht hinsichtlich der Y-Richtung bzw. hinsichtlich der Fast-Axis beugungsbegrenzt kollimiert werden. Um dies zu erreichen, kann die als Fast-Axis-Kollimationsmittel 2 dienende Zylinderlinse eine asphärische Oberfläche aufweisen. Anstelle der abgebildeten Zylinderlinse, die lediglich auf ihrer Austrittsweise eine konvexe Krümmung aufweist, kann auch eine Zylinderlinse mit einer konvex gekrümmten Eintrittsseite verwendet werden. Alternativ dazu besteht auch die Möglichkeit, sowohl die Eintrittsseite als auch die Austrittsseite konvex und/oder konkav zu krümmen.

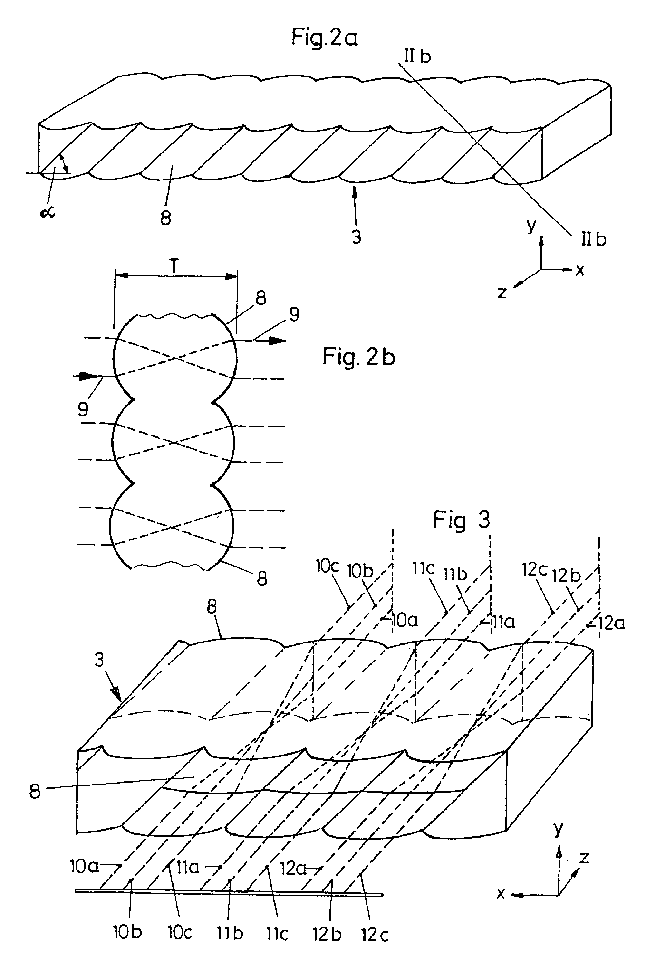

In Ausbreitungsrichtung Z schließen sich an die Fast-Axis-Kollimationsmittel 2 Strahltransformationsmittel 3 an, die insbesondere aus Fig. 2a, Fig. 2b und Fig. 3 detailliert ersichtlich sind. In den Strahltransformationsmitteln 3 wird das einfallende Licht um einen Winkel von 90° rotiert beziehungsweise die Divergenz der Fast-Axis (Y-Richtung) mit der der Slow-Axis (X-Richtung) getauscht, so dass nach dem Austritt aus der Vorrichtung 3 die Divergenz in Y-Richtung etwa 160 mrad und die Divergenz in X-Richtung etwa 3 mrad beträgt.

In Ausbreitungsrichtung Z des Laserlichtes schließen sich an die Strahltransformationsmittel 3 Slow-Axis-Kollimationsmittel 4 an, so dass ein Strahl von 10 mm x 10 mm mit Divergenz in Y-Richtung von etwa 11 mrad und Divergenz in X-Richtung von etwa 3 mrad erreicht werden kann. Die Zahlenwerte für Divergenz und Strahldurchmesser beziehen sich auf die volle Breite des Strahles bei der Hälfte der maximalen Intensität (FWHM).

Die Slow-Axis-Kollimationsmittel 4 sind als plankonvexe Zylinderlinse mit sich in X-Richtung erstreckender Zylinderachse ausgebildet. Aufgrund der Drehung des Laserlichtes in den Strahltransformationsmitteln 3 haben somit die Slow-Axis-Kollimationsmittel 4 die gleiche Ausrichtung wie die Fast-Axis-Kollimationsmittel 2. Ebenso wie die Fast-Axis-Kollimationsmittel 2 können auch die Slow-Axis-Kollimationsmittel 4 anders gestaltet werden. Insbesondere können sowohl Eintritts- als auch Austrittsfläche mit einer konvexen und/oder konkaven Krümmung versehen werden.

In Ausbreitungsrichtung Z schließen sich an die Slow-Axis-Kollimationsmittel 4 erste Homogenisatormittel 5 und daran anschließend zweite Homogenisatormittel 6 an. Die Homogenisatormittel 5 weisen auf ihrer Eintrittsfläche ein Array von Zylinderlinsen auf, deren Zylinderachsen sich in X-Richtung erstrecken. Weiterhin weisen die ersten Homogenisatormittel auf ihrer Austrittsfläche ein Array von Zylinderachsen auf, deren Zylinderachsen sich in Y-Richtung erstrecken. Durch die gekreuzt zueinander angeordneten Zylinderlinsenarrays auf der Eintritts- und Austrittsfläche der ersten Homogenisatormittel wird das durch die ersten Homogenisatormittel 5 hindurchgetretene Laserlicht sehr effektiv sowohl in Slow-Axis-Richtung als auch in Fast-Axis-Richtung bzw. sowohl in X-Richtung als auch in Y-Richtung miteinander überlagert. Durch diese effektive Überlagerung, die aus Fig. 1a und Fig. 1b durch die hinter den ersten Homogenisatormitteln 5 ersichtlichen Fokusbereiche verdeutlicht ist, kann eine Homogenisierung des Laserlichtes erreicht werden.

In Strahlausbreitungsrichtung Z hinter den ersten Homogenisatormitteln umfasst die Vorrichtung zweite Homogenisatormittel 6. Diese zweiten Homogenisatormittel 6 weisen auf ihrer Eintritts- und/oder Austrittsfläche ein Zylinderlinsenarray mit Zylinderlinsen auf, die sich in Y-Richtung erstrecken. Insgesamt wird somit das Laserlicht in zwei Stufen homogenisiert, wobei die zweite Stufe nur auf die Slow-Axis wirkt und die erste Stufe sowohl auf die Slow-Axis als auch auf die Fast-Axis.

Mit dem Bezugzeichen 7 ist das aus der erfindungsgemäßen Vorrichtung austretende weitestgehend kollimierte und homogenisierte Laserlicht 7 bezeichnet, das zur Ausleuchtung einer von der Vorrichtung entfernten Fläche verwendet werden kann.

Aus Fig. 2a und Fig. 2b ist eine Ausführungsform der Strahltransformationsmittel 3 ersichtlich. Es handelt sich um einen im wesentlichen quaderförmigen Block aus einem transparentem Material, auf dem sowohl auf der Eintrittsseite als auch auf der Austrittsseite eine Anzahl von als Strahltransformationselementen 8 dienenden Zylinderlinsensegmenten parallel zueinander angeordnet ist. Die Achsen der Strahltransformationselemente 8 schließen mit der Basisseite der quaderförmigen Strahltransformationsmittel 3, die in X-Richtung verläuft, einen Winkel α von 45° ein. In dem abgebildeten Ausführungsbeispiel sind etwa zehn Zylinderlinsensegmente nebeneinander auf jeder der beiden X-Y-Flächen der Strahltransformationsmittel 3 angeordnet. Aus Fig. 2b ist ersichtlich, das die in Z-Richtung gemessene Tiefe T der durch das Zylinderlinsenarray gebildeten Bikonvex-Zylinderlinsen gleich der zweifachen Brennweite einer jeder dieser Bikonvex-Zylinderlinsen ist. Dies entspricht

$$T = 2F_n$$

Hierbei ist T die Tiefe der als Zylinderlinsenarray ausgeführten Strahltransformationsmittel 3 und $F_n$ die Brennweite einer jeder der Bikonvex-Zylinderlinsen bei einem Brechungsindex n des gewählten Materials der Strahltransformationsmittel 3. Aus Fig. 2b ist ein schematischer Strahlengang von Laserlicht 9 ersichtlich, der verdeutlicht, dass eine jede der Bikonvex-Zylinderlinsen einen parallelen Lichtstrahl wiederum in einen parallelen Lichtstrahl überführt.

Aus Fig. 3 ist der Durchgang eines linienförmig auf die Strahltransformationsmittel 3 auftreffenden Lichtstrahls durch die Strahltransformationsmittel 3 am Beispiel von Teilstrahlen 10a, b, c, 11a, b, c, 12a, b, c ersichtlich. Die Teilstrahlen 10, 11, 12 sind zur Vereinfachung so dargestellt, als ob der Lichtstrahl nur eine Ausdehnung in X-Richtung aufweist. Weiterhin sind die Teilstrahlen 10, 11, 12 separat voneinander dargestellt, obwohl das von den einzelnen Emittern ausgehende Laserlicht 9 bereits vor dem Eintritt in die Strahltransformationsmittel überlappt. Die Strahltransformationsmittel 3 sind gemäß der Anordnung in Fig. 1a und Fig. 1b so ausgerichtet, dass die optisch funktionalen, mit den Zylinderlinsensegmenten versehenen Flächen im wesentlichen X-Y-Flächen sind.

Aus Fig. 3 ist ersichtlich, dass die Teilstrahlen 10, 11, 12 beim Durchgang durch die Strahltransformationsmittel 3 eine Drehung um 90° erfahren, so dass die einzelnen Teilstrahlen 10, 11, 12 nach dem Durchgang durch die Strahltransformationsmittel 3 jeweils nur noch in Y-Richtung ausgedehnt sind. Hierbei verläuft beispielsweise der Lichtstrahl 10b ungehindert durch die Strahltransformationsmittel 3 hindurch, wohingegen der links von ihm auf die Eintrittsfläche auftreffende Lichtstrahl 10a zur Mitte und nach unten hin abgelenkt wird und der auf die Eintrittsfläche rechts von ihm auftretende Lichtstrahl 10c zur Mitte und nach oben hin abgelenkt wird. Gleiches gilt für die Teilstrahlen 11 und 12.

Bei der erfindungsgemäßen Vorrichtung überlappen die aus einzelnen Emittern austretenden Teilstrahlen vor ihrem Eintritt in die Strahltransformationsmittel 3. Nach dem Durchgang durch die Strahltransformationsmittel 3 ist nur noch eine beugungsbegrenzte Restdivergenz in X-Richtung vorhanden, wohingegen die Divergenz in Y-Richtung der ursprünglichen Divergenz in X-Richtung von beispielsweise etwa 160 mrad entspricht.

In Fig. 4a und Fig. 4b ist der Strahlengang des Laserlichtes durch die Fast-Axis-Kollimationsmittel 2 und die Strahltransformationsmittel 3 ersichtlich. Insbesondere aufgrund der Tatsache, dass die aus einzelnen Emittern austretenden Teilstrahlen vor ihrem Eintritt in die Strahltransformationsmittel 3 überlappen, können einzelne Teilstrahlen 13 derart in Übergangsbereichen zwischen einzelnen der Strahltransformationselemente 8 auftreffen, dass sie aus dem sich im wesentlichen in Z-Richtung bewegenden Laserlicht herausgestreut werden. Diese Teilstrahlen sind in Fig. 4a und Fig. 4b deutlich ersichtlich. Es zeigt sich jedoch, dass der Anteil der aufgrund der Überlappung aus dem sich in Z-Richtung bewegenden Laserlicht herausgestreuten Teilstrahlen relativ gering ist, so dass maximal ein Verlust in den Strahltransformationsmitteln 3 von etwa 5% der eingestrahlten Leistung auftritt.

Aufgrund der Vertauschung der Divergenzen von Slow-Axis und Fast-Axis in den Strahltransformationsmitteln 3 wird ein weiteres Überlappen der aus den einzelnen Emittern ausgetretenen Teilstrahlen verhindert. Dadurch kann der Abstand zwischen den Strahltransformationsmitteln 3 und den Slow-Axis-Kollimationsmitteln 4 sehr groß gewählt werden, so dass die Kollimation durch die Slow-Axis-Kollimationsmittel 4 mit einer sehr langen Brennweite der dafür verwendeten Zylinderlinse erfolgen kann. Dadurch ergibt sich ein größerer Strahldurchmesser in Y-Richtung (siehe dazu Fig. 1 b) und dementsprechend aufgrund des konstanten Strahlparameterprodukts eine kleinere Divergenz. Auf diese Weise kann erreicht werden, dass nach anschließender Homogenisierung durch die Homogenisatormittel 5, 6 das Laserlicht optimal zur Beleuchtung einer entfernten Fläche verwendet werden kann.

## Patentansprüche

1. Vorrichtung für die Beleuchtung einer Fläche, umfassend:

   - mindestens einen Halbleiterlaserbarren (1) mit einer Mehrzahl von Emittern, die in einer ersten Richtung (X) nebeneinander und beabstandet zueinander angeordnet sind,

      - wobei der Abstand der einzelnen Emitter zueinander kleiner ist als die Ausdehnung der Emitter in der ersten Richtung (X)
      - und wobei die Divergenz des aus den einzelnen Emittern austretenden Laserlichts hinsichtlich der ersten Richtung (X) kleiner ist als die Divergenz des Laserlichts (9) hinsichtlich einer zu der ersten Richtung (X) senkrechten zweiten Richtung (Y);

      - sowie weiterhin umfassend Kollimationsmittel (2, 4) für die zumindest teilweise Kollimation des aus den Emittern austretenden Laserlichts;

**dadurch gekennzeichnet, dass**

- die Beleuchtungsvorrichtung Strahltransformationsmittel (3) zur Transformation des aus den Emittern austretenden Laserlichts umfasst, die derart ausgebildet und im Strahlengang des aus den Emittern austretenden Laseriichts angeordnet sind, dass sie die Divergenz des Laserlichts hinsichtlich der ersten Richtung (X) mit der Divergenz hinsichtlich der zweiten Richtung (Y) tauschen können,

- wobei die Strahltransformationsmittel (3) einen derartigen Abstand zu dem Laserdiodenbarren (1) aufweisen, dass zumindest das Laserlicht zweier direkt benachbarter Emitter bei dem Auftreffen auf die Strahltransformationsmittel (3) in der ersten Richtung (X) miteinander überlappt ist.

2. Vorrichtung für die Beleuchtung einer Fläche nach Anspruch 1 oder nach dem Oberbegriff des Anspruchs 1, **dadurch gekennzeichnet, dass** die Beleuchtungsvorrichtung Homogenisatormittel (5, 6) zur Homogenisierung des aus den Emittern austretenden Laserlichts (9) umfasst.

3. Vorrichtung für die Beleuchtung einer Fläche nach Anspruch 2, **dadurch gekennzeichnet, dass** die Homogenisatormittel (5, 6) mehrstufig ausgebildet sind.

4. Vorrichtung für die Beleuchtung einer Fläche nach Anspruch 3, **dadurch gekennzeichnet, dass** die Anzahl der Stufen der Homogenisatormittel (5, 6) für die Homogenisierung hinsichtlich der ersten Richtung (X) größer ist als für die Homogenisierung hinsichtlich der zweiten Richtung (Y).

5. Vorrichtung für die Beleuchtung einer Fläche nach einem der Ansprüche 1 bis 4, **dadurch gekennzeichnet, dass** die Strahltransformationsmittel (3) eine Mehrzahl von in der ersten Richtung (X) nebeneinander angeordneten Strahltransformationselementen (8) aufweisen.

6. Vorrichtung für die Beleuchtung einer Fläche nach Anspruch 5, **dadurch gekennzeichnet, dass** das von einem der Emitter ausgehende Laserlicht auf mehr als eines der Strahltransformationselemente (8) auftrifft.

7. Vorrichtung für die Beleuchtung einer Fläche nach einem der Ansprüche 5 oder 6, **dadurch gekennzeichnet, dass** die Strahltransformationselemente (8) als Zylinderlinsen ausgebildet sind, deren Zylinderachsen unter einem Winkel von etwa 45° und/oder -45° gegen die erste Richtung (X) geneigt sind.

8. Vorrichtung nach einem der Ansprüche 1 bis 7, **dadurch gekennzeichnet, dass** die Homogenisatormittel (5, 6) eine Mehrzahl von in der ersten Richtung (X) nebeneinander angeordneten Homogenisatorelementen aufweisen, die insbesondere als Zylinderlinsen ausgebildet sind.

9. Vorrichtung nach Anspruch 8, **dadurch gekennzeichnet, dass** der Mittenabstand der Strahltransformationselemente (8) zueinander ungleich dem Mittenabstand der Homogenisatorelemente zueinander ist.

10. Vorrichtung nach einem der Ansprüche 1 bis 9, **dadurch gekennzeichnet, dass** die Kollimationsmittel (2, 4) Fast-Axis-Kollimationsmittel (2) umfassen, die zur Kollimierung des aus den Emittern austretenden Laserlichtes hinsichtlich der zweiten Richtung (Y) dienen.

11. Vorrichtung für die Beleuchtung einer Fläche nach einem der Ansprüche 1 bis 10, **dadurch gekennzeichnet, dass** die Kollimationsmittel (2, 4) Slow-Axis-Kollimationsmittel (4) umfassen, die zur Kollimierung des aus den Emittern austretenden Laserlichtes hinsichtlich der ersten Richtung (X) dienen.

12. Vorrichtung nach einem der Ansprüche 1 bis 11, **dadurch gekennzeichnet, dass** der Abstand der einzelnen Emitter zueinander in der ersten Richtung (X) weniger als die Hälfte, insbesondere weniger als ein Zehntel, der Ausdehnung eines jeden der Emitter in der ersten Richtung (X) beträgt.

13. Vorrichtung für die Beleuchtung einer Fläche nach einem der Ansprüche 1 bis 12, **dadurch gekennzeichnet, dass** der Halbleiterlaserbarren (1) als QCW-Barren ausgeführt ist.

# Fig. 1a

# Fig. 1b

## Fig.2a

## Fig. 2b

## Fig 3

## Fig. 4a

## Fig. 4b

**Europäisches Patentamt**

## EUROPÄISCHER RECHERCHENBERICHT

Nummer der Anmeldung

EP 05 01 4423

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | EP 1 376 197 A (NIPPON STEEL CORPORATION; NIPPON BUNRI UNIVERSITY) 2. Januar 2004 (2004-01-02) * Absätze [0032] - [0056]; Abbildung 6 * ----- | 1-13 | G02B27/09 H01S3/00 |
| D,A | EP 1 006 382 A (LISSOTSCHENKO, VITALIJ; HENTZE, JOACHIM) 7. Juni 2000 (2000-06-07) * Absätze [0011] - [0013], [0018] * ----- | 1-13 | |
| A | US 6 384 981 B1 (HAUSCHILD DIRK) 7. Mai 2002 (2002-05-07) * Spalte 1, Zeile 23 - Spalte 2, Zeile 9; Abbildung 1 * ----- | 1 | |

| | RECHERCHIERTE SACHGEBIETE (Int.Cl.7) |
|---|---|
| | G02B H01S |

Der vorliegende Recherchenbericht wurde für alle Patentansprüche erstellt

| Recherchenort | Abschlußdatum der Recherche | Prüfer |
|---|---|---|
| München | 16. September 2005 | Rödig, C |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 05 01 4423

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

16-09-2005

| Im Recherchenbericht angeführtes Patentdokument | | Datum der Veröffentlichung | Mitglied(er) der Patentfamilie | | Datum der Veröffentlichung |
|---|---|---|---|---|---|
| EP 1376197 | A | 02-01-2004 | CA | 2442712 A1 | 17-10-2002 |
| | | | CN | 1500223 A | 26-05-2004 |
| | | | WO | 02082163 A1 | 17-10-2002 |
| | | | US | 2004091013 A1 | 13-05-2004 |
| EP 1006382 | A | 07-06-2000 | JP | 2000137139 A | 16-05-2000 |
| | | | US | 6471372 B1 | 29-10-2002 |
| US 6384981 | B1 | 07-05-2002 | AT | 211316 T | 15-01-2002 |
| | | | DE | 19819333 A1 | 04-11-1999 |
| | | | WO | 9957791 A1 | 11-11-1999 |
| | | | EP | 1075719 A1 | 14-02-2001 |
| | | | JP | 2002513959 T | 14-05-2002 |

EPO FORM P0461

Für nähere Einzelheiten zu diesem Anhang : siehe Amtsblatt des Europäischen Patentamts, Nr.12/82